# EUROPEAN PATENT SPECIFICATION

(11) **EP 1 820 834 B1**
(45) Date of publication and mention of the grant of the patent: **27.08.2008**
(21) Application number: 07003054.9
(22) Date of filing: 13.02.2007
(51) Int. Cl.: C09J 7/00

(54) **Pressure-sensitive adhesive tape**
Druckempfindliches Klebeband
Ruban adhesif autocollant

(30) Priority: 16.02.2006 JP 2006039048
(43) Date of publication of application: 22.08.2007
(73) Proprietor: NITTO DENKO CORPORATION, Osaka (JP)
(72) Inventor: Asai, Fumiteru, Ibaraki-shi Osaka (JP); Shintani, Toshio, Ibaraki-shi Osaka (JP); Okawa, Yuji, Ibaraki-shi Osaka (JP); Takahashi, Tomokazu, Ibaraki-shi Osaka (JP)
(74) Representative: Grünecker, Kinkeldey, Stockmair & Schwanhäusser Anwaltssozietät

(56) References cited:
- EP-A- 1 702 967
- WO-A-20/04074386
- JP-A- 1 249 879
- US-A1- 4 826 938

## Description

### FIELD OF THE INVENTION

The present invention relates to a pressure-sensitive adhesive tape or sheet for application to an active surface in dicing and a method of picking up chips of a work with the pressure-sensitive adhesive tape or sheet for application to an active surface in dicing. More particularly, the invention relates to a pressure-sensitive adhesive tape or sheet for application to an active surface in dicing which is used in such a manner that, when a work made of a material comprising a compound such as a silicon compound, germanium compound, or gallium-arsenic compound (e.g., a semiconductor wafer, semiconductor package, glass, or ceramic) is to be diced and the resultant chips are to be picked up, the tape or sheet is applied to that active surface of the work which is in the state of being not wholly covered with a native oxide film. The invention further relates to a method of picking up chips of a work using the pressure-sensitive adhesive tape or sheet for application to an active surface in dicing.

### BACKGROUND OF THE INVENTION

In a general process heretofore in use, a semiconductor wafer employing a compound such as a silicon compound, germanium compound, or gallium-arsenic compound as a material is produced in a large-diameter form, subjected to back grinding so as to result in a given thickness, and then subjected to back processing (e.g., etching or polishing) according to the necessity. Subsequently, a pressure-sensitive adhesive tape or sheet for dicing is applied to the back side of the semiconductor wafer. Thereafter, this wafer is cut (diced) into element chips and then subjected to various steps such as a cleaning step, expanding step, pickup step, and mounting step.

The pressure-sensitive adhesive tape or sheet for dicing generally has a constitution including a substrate constituted of a plastic film or the like and a pressure-sensitive adhesive layer (thickness, about 1 to 50 µm) formed on the substrate by applying a pressure-sensitive adhesive composition such as an acrylic pressure-sensitive adhesive, and drying it. The pressure-sensitive adhesive tape or sheet for dicing is required to have adhesive force sufficient to prevent the semiconductor wafer from separating from the tape or sheet during dicing. From this standpoint, the pressure-sensitive adhesive tapes or sheets which have generally been used hitherto for dicing are those having a peeling adhesive force in the pickup of, e.g., a silicon mirror wafer (peel angle: 15°; pulling rate: 150 mm/min; temperature in application: 23°C; temperature in peeling, 23°C) of 2.5 (N/25mm width) or higher. On the other hand, the adhesive force is required to be low in such a degree that in pickup after dicing, the semiconductor wafer can be easily separated from the tape or sheet without breaking. Furthermore, one of the important properties required for pressure-sensitive adhesive tapes or sheets for dicing is the property of less apt to cause contamination, e.g., not to leave an adhesive residue on the semiconductor chips (the phenomenon in which an ingredient in the pressure-sensitive adhesive layer remains on the adherend surface). Disclosed as a pressure-sensitive adhesive tape or sheet for dicing which has such properties is, for example, a removable pressure-sensitive adhesive sheet having a pressure-sensitive adhesive layer constituted of a polymer in which the content of low-molecular components having a molecular weight of 10⁵ or lower is 10% by weight or lower (see patent document 1).

Incidentally, the pickup step is usually conducted after the expanding step, in which the space between semiconductor chips is enlarged. The expanding step is a step in which the semiconductor chips are made easily separable from the pressure-sensitive adhesive tape or sheet for dicing. This expanding step is accomplished, for example, by keeping the pressure-sensitive adhesive tape or sheet for dicing in the state of being stretched in some degree and lifting up that point area or linear area of the pressure-sensitive adhesive tape or sheet for dicing which underlies the semiconductor chip to be picked up. In the method which is being mainly employed currently, semiconductor chips are brought into such an easily separable state and then held from the upper side with suction (vacuum holding) and picked up.

In recent years, however, the case where a semiconductor wafer is bonded to a pressure-sensitive adhesive tape or sheet for dicing in several hours after completion of a wafer back grinding step or after completion of a wafer back grinding step and a subsequent grinding dust layer removal step (step of mechanical grinding dust layer removal, chemical grinding dust layer removal, or both of them) is becoming frequent for the purposes of improving tact time, preventing semiconductor wafers having a reduced thickness from breaking, etc. Examples of the grinding dust layer removal step include various treatments including a dry polishing treatment, so-called "CMP" treatment, wet etching treatment, and dry etching treatment.

When a pressure-sensitive adhesive tape or sheet for dicing is thus applied to the ground surface (processed surface) of a semiconductor wafer in several hours after completion of a wafer back grinding step or after completion of a grinding dust layer removal step after grinding, there is a problem that the adhesive force increases as time passes after the application (with the lapse of time), resulting in a decrease in suitability for pickup. The reasons for this are presumed to be as follows. The ground surface of the semiconductor wafer has not been wholly covered with a native oxide film and is an active surface in which active atoms in an unoxidized state are present. Since the pressure-sensitive adhesive tape or sheet for dicing has been applied to such active surface not wholly covered with a native oxide film, the active atoms in an unoxidized state (e.g., silicon atoms) react with a component of the pressure-sensitive adhesive layer to form chemical bonds between the unoxidized active atoms and the component of the pressure-sensitive adhesive layer and thereby pose that problem.

Herein, the term "active surface" means a surface which is in the state of being not wholly covered with a native oxide film. Specifically, this term means a surface which is not wholly covered with a native oxide film and in which active atoms in an unoxidized state (e.g., atoms reactive with a component of the pressure-sensitive adhesive layer) are present.
Patent Document 1 : JP-A-2001-234136

### SUMMARY OF THE INVENTION

Accordingly, an object of the invention is to provide a pressure-sensitive adhesive tape or sheet for application to an active surface in dicing which, even when kept bonded to an active surface for a prolonged period of time, enables the chips to be easily picked up. Another object of the invention is to provide a method of picking up chips of a work, which includes using the pressure-sensitive adhesive tape or sheet for application to an active surface in dicing.

The present inventors made intensive investigations in order to accomplish those objects. As a result, it has been found that, when a pressure-sensitive adhesive tape or sheet for dicing which employs a specific acrylic polymer as a base polymer and contains a specific radiation-polymerizable compound is used as a pressure-sensitive adhesive tape or sheet for dicing and applied to the ground surface, as an active surface, of a semiconductor wafer immediately after back grinding (back processing) of the wafer, then this pressure-sensitive adhesive tape or sheet can be easily stripped off even after the passage of a prolonged time period. The invention has been completed based on this finding.

### BRIEF DESCRIPTION OF THE DRAWINGS

Fig. 1 is a diagrammatic sectional view illustrating one embodiment of the pressure-sensitive adhesive tape or sheet for application to an active surface in dicing of the invention.
Fig. 2 is a diagrammatic sectional view illustrating a method of measuring the adhesive force of a pressure-sensitive adhesive tape or sheet for application to an active surface in dicing.

### Description of Reference Numerals and Signs

1 pressure-sensitive adhesive tape or sheet for application to active surface in dicing
2 substrate
3 radiation-curable pressure-sensitive adhesive layer
4 separator
5 pressure-sensitive adhesive tape or sheet for application to active surface in dicing
51 substrate
52 radiation-curable pressure-sensitive adhesive layer (X)
6 silicon mirror wafer
X direction in which pressure-sensitive adhesive tape or sheet 5 for application to active surface in dicing is stripped off (stripping direction)
θ angle between the surface of radiation-curable pressure-sensitive adhesive layer (X) 52 and the surface of silicon mirror wafer 6 (peel angle) during stripping of pressure-sensitive adhesive tape or sheet 5 for application to active surface in dicing

### DETAILED DESCRIPTION OF THE INVENTION

Namely, the invention relates to the following (1) to (7).
(1) A pressure-sensitive adhesive tape or sheet for dicing, which comprises:
   a substrate, and
   a radiation-curable pressure-sensitive adhesive layer disposed on at least one side of the substrate,
   said pressure-sensitive adhesive layer containing an acrylic polymer (A) having a weight-average molecular weight of 500,000 or higher and at least one radiation-polymerizable compound (B) selected from cyanurate compounds having one or more groups containing a carbon-carbon double bond and isocyanurate compounds having one or more groups containing a carbon-carbon double bond, wherein the ratio of the radiation-polymerizable compound (B) with respect to 100 parts by weight of the acrylic polymer (A) is 5 to 150 parts by weight, and
   wherein said pressure-sensitive adhesive tape or sheet is to be applied to an active surface in the state of being not wholly covered with a native oxide film.
(2) The pressure-sensitive adhesive tape or sheet according to (1) above, wherein the radiation-polymerizable compound (B) has, in the molecule thereof, 2 to 12 groups containing a carbon-carbon double bond.
(3) The pressure-sensitive adhesive tape or sheet according to (2) above, wherein the radiation-polymerizable compound (B) has, in the molecule thereof, 3 to 10 groups containing a carbon-carbon double bond.
(4) The pressure-sensitive adhesive tape or sheet according to (1) above, wherein said one or more groups containing a carbon-carbon double bond in the radiation-polymerizable compound (B) each independently are a group selected from vinyl, allyl, acryloxy, and methacryloxy.
(5) The pressure-sensitive adhesive tape or sheet according to (1) above, wherein the acrylic polymer (A) has a weight-average molecular weight of 800,000 or higher.
(6) The pressure-sensitive adhesive tape or sheet according to (1), wherein the acrylic polymer (A) has one or more carbon-carbon double bonds in the side chain or main chain thereof or at the ends of the main chain thereof.
(7) The pressure-sensitive adhesive tape or sheet according to (1) above, wherein the ratio of the radiation-polymerizable compound (B) with respect to 100 parts by weight of the acrylic polymer (A) is 20 to 120 parts by weight.
   The radiation-polymerizable compound (B) preferably has, in the molecule thereof, 2 to 12 groups containing a carbon-carbon double bond. Preferably, the one or more groups containing a carbon-carbon double bond in the radiation-polymerizable compound (B) each independently are a group selected from vinyl, allyl, acryloxy, and methacryloxy.
   In addition, the invention further relates to the following (8).
(8) A method of picking up chips of a work, which comprises:
   applying the pressure-sensitive adhesive tape or sheet according to (1) above to an active surface of a work, followed by dicing the work to prepare chips; and
   picking up the chips.

The pressure-sensitive adhesive tape or sheet for application to an active surface in dicing of the invention, even after having been kept bonded to an active surface over a prolonged time period, enables the chips to be easily picked up, since it has the constitution described above.

The pressure-sensitive adhesive tape or sheet for application to an active surface in dicing of the invention has a constitution which includes a substrate and a radiation-curable pressure-sensitive adhesive layer disposed on at least one side of the substrate and in which the radiation-curable pressure-sensitive adhesive layer on at least one side of the substrate contains an acrylic polymer (A) having a weight-average molecular weight of 500,000 or higher (often referred to simply as "acrylic polymer (A)" hereinafter) and at least one radiation-polymerizable compound (B) selected from cyanurate compounds having one or more groups containing a carbon-carbon double bond and isocyanurate compounds having one or more groups containing a carbon-carbon double bond (often referred to simply as "radiation-polymerizable compound (B)" hereinafter), in which the ratio of the radiation-polymerizable compound (B) with respect to 100 parts by weight of the acrylic polymer (A) is 5 to 150 parts by weight. Since the pressure-sensitive adhesive tape or sheet for application to an active surface in dicing of the invention has the constitution described above, in which the radiation-curable pressure-sensitive adhesive layer on at least one side of the substrate contains an acrylic pressure-sensitive adhesive based on an acrylic polymer (A) having a weight-average molecular weight of 500,000 or higher and a radiation-polymerizable compound (B) incorporated in the adhesive in a given proportion, the radiation-curable pressure-sensitive adhesive layer can be cured upon irradiation with a radiation to form a three-dimensional network structure which is effective against the active surface. Therefore, even after the pressure-sensitive adhesive tape or sheet for application to an active surface in dicing of the invention has been kept bonded to an active surface over a prolonged time period, the force of adhesion to the active surface can be effectively reduced by irradiation with a radiation. Thus, the chips can be easily picked up in the course of picking up the chips.

With regard to the radiation-polymerizable compound (B), it is important that the groups containing a carbon-carbon double bond should have the property of being polymerized by irradiation with a radiation (radiation polymerizability).

### Acrylic Polymer (A)

The acrylic polymer (A) is an acrylic polymer having a weight-average molecular weight of 500,000 or higher (e.g., 500,000 to 5,000,000) and may used as the base polymer of radiation-curable pressure-sensitive adhesive compositions. When the weight-average molecular weight of the acrylic polymer (A) is lower than 500,000, there are cases where the property of prevention of contamination to works such as semiconductor wafers is reduced and the pressure-sensitive adhesive tape or sheet leaves an adhesive residue after application to an active surface and later stripping therefrom. Preferably, the acrylic polymer (A) has a low content of low-molecular substances (components). From this standpoint, the weight-average molecular weight of the acrylic polymer (A) is preferably 800,000 or higher (e.g., 800,000 to 3,000,000).

The acrylic polymer (A) is a polymer (homopolymer or copolymer) containing a (meth)acrylic ester as the main monomer ingredient. Examples of the (meth)acrylic esters as the main monomer ingredient for the acrylic polymer (A) include alkyl esters of (meth)acrylic acid, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, and octadecyl (meth)acrylate; cycloalkyl esters of (meth)acrylic acid, such as cyclohexyl (meth)acrylate; and aryl esters of (meth)acrylic acid, such as phenyl (meth) acrylate. Such (meth)acrylic esters can be used alone or in combination of two or more thereof. Preferred (meth)acrylic esters are alkyl esters of (meth)acrylic acid, such as methyl (meth)acrylate, ethyl (meth)acrylate, butyl (meth)acrylate, 2-ethylhexyl (meth)acrylate, and octyl (meth)acrylate.

In producing the acrylic polymer (A), one or more monomers copolymerizable with the (meth)acrylic esters (copolymerizable monomers) may be used as monomer ingredients for the purpose of, for example, modifying properties such as cohesive force and heat resistance according to the necessity. Copolymerizable monomers can be used alone or in combination of two or more thereof. Examples of the copolymerizable monomers include carboxyl-containing monomers such as (meth)acrylic acid (acrylic acid and methacrylic acid), carboxyethyl (meth)acrylate, carboxypentyl (meth)acrylate, itaconic acid, maleic acid, fumaric acid, crotonic acid, and isocrotonic acid; monomers containing an acid anhydride group, such as maleic anhydride and itaconic anhydride; hydroxyl-containing monomers such as 2-hydroxyethyl (meth)acrylate, 2-hydroxypropyl (meth)acrylate, 4-hydroxypropyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl (meth)acrylate, vinyl alcohol, allyl alcohol, 2-hydroxyethyl vinyl ether, 2-hydroxypropyl vinyl ether, 4-hydroxybutyl vinyl ether, ethylene glycol monovinyl ether, diethylene glycol monovinyl ether, propylene glycol monovinyl ether, and dipropylene glycol monovinyl ether; monomers containing an sulfonate group such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; monomers containing a phosphate group, such as 2-hydroxyethyl acryloylphosphate; amide monomers such as (meth)acrylamide, N,N-dimethyl(meth)acrylamide, N-butyl(meth)acrylamide, N-methylol(meth)acrylamide, N-methylolpropyl(meth)acrylamide, N-methoxymethyl(meth)acrylamide, and N-butoxymethyl(meth)acrylamide; cyano-containing monomers such as (meth)acrylonitrile; amino-containing monomers such as aminoethyl (meth)acrylate, N,N-dimethylaminoethyl (meth)acrylate, and t-butylaminoethyl (meth)acrylate; epoxy-containing monomers such as glycidyl (meth)acrylate and methylglycidyl (meth)acrylate; olefin monomers such as ethylene, propylene, isopropylene, butadiene, and isobutylene; styrene monomers such as styrene, α-methylstyrene, and vinyltoluene; vinyl ester monomers such as vinyl acetate and vinyl propionate; vinyl ether monomers such as methyl vinyl ether and ethyl vinyl ether; monomers containing one or more halogen atoms, such as vinyl chloride and vinylidene chloride; monomers containing an isocyanate group, such as (meth)acryloylisocyanates, (meth)acryloyloxymethyl isocyanate, 2-(meth)acryloyloxyethyl isocyanate, 2-(meth)acryloyloxypropyl isocyanate, 3-(meth)acryloyloxypropyl isocyanate, 4-(meth)acryloyloxybutyl isocyanate, and m-propenyl-α,α-dimethylbenzyl isocyanate; and monomers having a ring containing one or more nitrogen atoms, such as N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and N-(meth)acryloylmorpholine.

According to the necessity, polyfunctional monomers may be used as copolymerizable monomers for the purpose of crosslinking, etc. Examples of the polyfunctional monomers include 1,6-hexanediol (meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, glycerol di(meth)acrylate, epoxy (meth)acrylates, polyester (meth)acrylates, urethane (meth)acrylates, divinylbenzene, butylene di(meth)acrylate, and hexylene di(meth)acrylate.

The amount (proportion) of the copolymerizable monomers to be used is preferably 40% by weight or less based on the total amount of all monomer ingredients. In the case where a polyfunctional monomer is employed as a copolymerizable monomer, the amount of the polyfunctional monomer to be used is preferably 30% by weight or less based on the total amount of all monomer ingredients from the standpoint of pressure-sensitive adhesive properties, etc.

The acrylic polymer (A) can be prepared by polymerizing a single monomer ingredient or a mixture of two or more monomer ingredients. The polymerization can be conducted by any of the solution polymerization method, emulsion polymerization method, bulk polymerization method, suspension polymerization method, and the like.

In the invention, it is preferred that the acrylic polymer (A) to be used is an acrylic polymer having one or more carbon-carbon double bonds in the side chain or main chain thereof or at the ends of the main chain thereof (this polymer is often referred to as "double-bond-containing acrylic polymer" hereinafter). In the case where the acrylic polymer (A) is a double-bond-containing acrylic polymer, the following advantage is brought about. When the pressure-sensitive adhesive tape or sheet for application to an active surface in dicing is applied to an active surface and the force of adhesion to the active surface is to be reduced thereafter by irradiation with a radiation, then the force of adhesion to the active surface can be reduced more effectively without the need of adding a low-molecular ingredient such as another radiation-curable monomer or oligomer.

A preferred example of this double-bond-containing acrylic polymer is a double-bond-containing acrylic polymer in which at least 1/100 of the side chains in the molecule each have one carbon-carbon double bond (often referred to as "side-chain double-bond type acrylic polymer" hereinafter). To thus introduce carbon-carbon double bonds into side chains of an acrylic polymer is advantageous also from the standpoint of molecule design. This side-chain double-bond type acrylic polymer may have carbon-carbon double bonds also in the main chain and at the end of the main chain. Such double-bond-containing acrylic polymers do not necessarily contain low-molecular ingredients such as an oligomer ingredient or do not contain such ingredients in a large amount. Therefore, the migration of low-molecular ingredients such as an oligomer ingredient in a pressure-sensitive adhesive layer with the lapse of time can be inhibited or prevented and a pressure-sensitive adhesive layer having a stable layer structure can be formed.

Methods for preparing a double-bond-containing acrylic polymer (i.e., methods for introducing carbon-carbon double bonds into an acrylic polymer) are not particularly limited, and a method suitably selected from various conventional methods can be employed. Examples of methods for preparing a double-bond-containing acrylic polymer (i.e., methods for introducing carbon-carbon double bonds into an acrylic polymer) include a method which comprises copolymerizing monomers including a monomer having a functional group as a copolymerizable monomer to prepare an acrylic polymer containing the functional group (often referred to as "functional-group-containing acrylic polymer" hereinafter) and then causing a compound having both a functional group reactive with the functional group contained in the functional-group-containing acrylic polymer and a carbon-carbon double bond (this compound is often referred to as "reactive compound containing a carbon-carbon double bond" hereinafter) to undergo condensation reaction or addition reaction with the functional-group-containing acrylic polymer while maintaining the radiation curability (radiation polymerizability) of the carbon-carbon double bond to thereby prepare a double-bond-containing acrylic polymer. Examples of control methods usable in introducing a carbon-carbon double bond into each of at least 1/100 of all side chains of an acrylic polymer include a method in which the amount of the reactive compound containing a carbon-carbon double bond to be subjected to condensation reaction or addition reaction with the functional-group-containing acrylic polymer is suitably regulated. When the reactive compound containing a carbon-carbon double bond is subjected to condensation reaction or addition reaction with the functional-group-containing acrylic polymer, a catalyst can be used to thereby enable the reaction to proceed effectively. Although the catalyst is not particularly limited, it preferably is a tin catalyst (in particular, dibutyltin dilaurate). The amount of the catalyst (tin catalyst such as dibutyltin dilaurate) to be used is not particularly limited. For example, the amount thereof is preferably about 0.05 to 1 part by weight with respect to 100 parts by weight of the functional-group-containing acrylic polymer.

In the side-chain double-bond type acrylic polymer, the proportion of side chains in each of which a carbon-carbon double bond is introduced is preferably 1/100 or more (from 1/100 to 100/100), especially preferably from 10/100 to 98/100 (in particular, from 50/100 to 95/100), in terms of the proportion in number of such side chains to the functional groups (e.g., hydroxyl groups) in all side chains, as stated above. Consequently, the proportion of the side chains in the side-chain double-bond type acrylic polymer, in each of which a carbon-carbon double bond is introduced, can be controlled, for example, by suitably regulating the amount of the reactive compound containing a carbon-carbon double bond to be used based on the number of functional groups in the functional-group-containing acrylic polymer.

Examples of combinations of the functional group in the functional-group-containing acrylic polymer and the functional group in the reactive compound containing a carbon-carbon double bond include various combinations such as a combination of a carboxylic acid group (carboxyl group) and an epoxy group, a combination of a carboxylic acid group and an aziridyl group, and a combination of a hydroxyl group and an isocyanate group. Preferred of these combinations of functional groups from the standpoint of reaction traceability, etc. is a combination of a hydroxyl group and an isocyanate group. In each of those combinations of functional groups, either of the functional groups may be the functional group of the functional-group-containing acrylic polymer or of the reactive compound containing a carbon-carbon double bond. However, in the case of a combination of a hydroxyl group and an isocyanate group, for example, it is preferred that the hydroxyl group be the functional group in the functional-group-containing acrylic polymer and the isocyanate group be the functional group in the reactive compound containing a carbon-carbon double bond. In this case, examples of the reactive compound containing a carbon-carbon double bond which contains an isocyanate group as a functional group (i.e., isocyanate compound containing a carbon-carbon double bond) include (meth)acryloylisocyanates, (meth)acryloyloxymethyl isocyanate, 2-(meth)acryloyloxyethyl isocyanate, 2-(meth)acryloyloxypropyl isocyanate, 3-(meth)acryloyloxypropyl isocyanate, 4-(meth)acryloyloxybutyl isocyanate, and m-propenyl-α,α-dimethylbenzyl isocyanate. On the other hand, examples of the functional-group-containing acrylic polymer containing a hydroxyl group as the functional group include hydroxyl-containing acrylic polymers obtainable by copolymerizing monomers including a hydroxyl-containing monomer [e.g., 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl (meth)acrylate, vinyl alcohol, allyl alcohol, 2-hydroxyethyl vinyl ether, 2-hydroxypropyl vinyl ether, 4-hydroxybutyl vinyl ether, ethylene glycol monovinyl ether, diethylene glycol monovinyl ether, propylene glycol monovinyl ether, or dipropylene glycol monovinyl ether] as a copolymerizable monomer.

The double-bond-containing acrylic polymer is cured by irradiation with a radiation, and this curing reaction proceeds more readily when a photopolymerization initiator is present in the system. As the photopolymerization initiator can be used a photopolymerization initiator for use in curing the radiation-polymerizable compound (B) by irradiation with a radiation.

The acrylic polymer (A) may have been regulated so as to have a weight-average molecular weight of 500,000 or higher by crosslinking with a crosslinking agent. The crosslinking agent is not particularly limited, and use may be made of one suitably selected from conventional crosslinking agents (e.g., polyisocyanate crosslinking agents, epoxy crosslinking agents, aziridine compound crosslinking agents, melamine resin crosslinking agents, urea resin crosslinking agents, acid anhydride crosslinking agents, polyamine crosslinking agents, and carboxyl-containing polymeric crosslinking agents). The amount of the crosslinking agent to be used is not particularly limited, and can be suitably determined according to a balance with the polymer to be crosslinked (the acrylic polymer (A) in an uncrosslinked state), intended use of the pressure-sensitive adhesive, etc. In general, the amount of the crosslinking agent to be used is preferably 0.01 to 5 parts by weight with respect to 100 parts by weight of the polymer to be crosslinked.

In the case where the acrylic polymer (A) is to be crosslinked with a crosslinking agent, it is important that the acrylic polymer (A) should be an acrylic polymer having a functional group (reactive functional group) which is reactive with the crosslinking agent (e.g., a double-bond-containing acrylic polymer having a functional group reactive with the crosslinking agent such as hydroxyl or carboxyl group).

### Radiation-Polymerizable Compound (B)

The radiation-polymerizable compound (B) is at least one member selected from cyanurate compounds having one or more groups containing a carbon-carbon double bond (often referred to as "carbon-carbon double-bond group" hereinafter) (these compounds are often referred to as "cyanurate compounds containing carbon-carbon double bond(s)" hereinafter) and isocyanurate compounds having one or more groups containing a carbon-carbon double bond (often referred to as "isocyanurate compounds containing carbon-carbon double bond(s)" hereinafter). The cyanurate compounds containing carbon-carbon double bond(s) or the isocyanurate compounds containing carbon-carbon double bond(s) each have a triazine ring or isotriazine ring (isocyanurate ring) in the molecule thereof and further have one or more radiation-polymerizable carbon-carbon double bonds. Such radiation-polymerizable compound (B) preferably is a monomer, an oligomer, or a mixture of two or more of monomers and oligomers.

Methods for preparing the radiation-polymerizable compound (B) are not particularly limited. In general, the radiation-polymerizable compound (B) can be prepared by subjecting a halocyanide, dianiline compound, diisocyanate compound, or the like as a starting material to an ordinary cyclization reaction to prepare a compound having a triazine ring or isotriazine ring and then incorporating one or more radiation-polymerizable carbon-carbon double bond groups (e.g., vinyl, allyl, acryloxy, or methacryloxy groups) into the compound.

It is preferred in the invention that the radiation-polymerizable compound (B) has two or more carbon-carbon double-bond groups in the molecule thereof from the standpoint of effectively forming a three-dimensional network structure by irradiation with a radiation. Especially, when the radiation-polymerizable compound (B) is a monomer, the monomer preferably has two or more carbon-carbon double-bond groups per molecule. On the other hand, in the case of an oligomer, the oligomer preferably has two or more carbon-carbon double-bond groups per repeating unit. The number of carbon-carbon double-bond groups contained in the radiation-polymerizable compound (B) is more preferably 2 to 12, especially preferably 3 or larger (in particular, 3 to 10). When the number of carbon-carbon double-bond groups contained in the radiation-polymerizable compound (B) is smaller than 2, there are cases where irradiation with a radiation cannot give a degree of crosslinking sufficient to reduce adhesive force. When the number thereof exceeds 12, there are cases where irradiation with a radiation excessively embrittles the pressure-sensitive adhesive.

Preferred examples of the carbon-carbon double-bond groups include vinyl, allyl, acryloxy, and methacryloxy groups. The carbon-carbon double-bond groups may be of one kind or may be a combination of two or more kinds.

In the radiation-polymerizable compound (B), the carbon-carbon double-bond groups each are generally bonded to any of the nitrogen atoms constituting the triazine ring or isotriazine ring through another group (often referred to as "connecting group" hereinafter) or without via a connecting group. It is preferred that neither the carbon-carbon double-bond groups nor the connecting group between each carbon-carbon double-bond group and the triazine ring or isotriazine ring (in particular, the carbon-carbon double-bond groups) has a so-called "rigid molecular structure" (e.g., a molecular structure having an aromatic ring or a molecular structure having a heterocycle). In a case where the carbon-carbon double-bond groups or the connecting group has rigidity, excess rigidity is imparted to the radiation-polymerizable compound (B) and the radiation-curable pressure-sensitive adhesive layer is excessively embrittled by irradiation with a radiation (e.g., ultraviolet). There are hence cases where the curing arouses a trouble, for example, that the pressure-sensitive adhesive layer which has embrittled cracks upon expanding or pickup in a pickup step.

It is therefore preferred that the carbon-carbon double-bond groups and the connecting group each contain a group rich in the free rotation of atoms. Examples of the group rich in the free rotation of atoms include divalent organic groups containing neither an aromatic ring nor a heterocycle, such as aliphatic hydrocarbon groups (e.g., alkylene groups such as methylene, ethylene, trimethylene, tetramethylene, pentamethylene, hexamethylene, heptamethylene, and octamethylene and the alkylidene groups corresponding to these alkylene groups), oxy (-O-), carbonyl (-CO-), oxycarbonyl (-OCO-), carbonyloxy (-COO-), iminocarbonyl (-NHCO-), carbonylamino (-CONH-), iminocarbonyloxy (-NHCOO-), and oxycarbonylamino (-OCONH-); and groups including a combination of two or more of these groups (e.g., groups each constituted of an aliphatic hydrocarbon group and at least one divalent organic group selected from oxy, carbonyl, oxycarbonyl, carbonyloxy, iminocarbonyl, carbonylamino, iminocarbonyloxy, and oxycarbonylamino groups).

In the case where a carbon atom constituting a carbon-carbon double bond is bonded to a triazine ring or a isotriazine ring through an oxy group, it is preferred that the carbon atom constituting the carbon-carbon double bond (the carbon atom on the triazine ring or isotriazine ring side) be bonded to the triazine ring or isotriazine ring through an alkyleneoxy group or alkylideneoxy group. It is especially preferred that the carbon atom constituting the carbon-carbon double bond be bonded to the triazine ring or isotriazine ring through an alkyleneoxy group having 2 or more carbon atoms or through an alkylideneoxy group having 2 or more carbon atoms. In this case, when two or more carbon-carbon double-bond groups are bonded to one triazine ring or isotriazine ring, then it is preferred that at least one of the carbon-carbon double-bond groups be one in which a carbon atom constituting the carbon-carbon double bond is bonded to the triazine ring or isotriazine ring through an alkyleneoxy group having 2 or more carbon atoms or through an alkylideneoxy group having 2 or more carbon atoms.

Specifically, examples of the cyanurate compounds containing carbon-carbon double bond(s) for use as the radiation-polymerizable compound (B) include 2-propenyl-di-3-butenyl cyanurate. Further, examples of the isocyanurate compounds containing carbon-carbon double bond(s) include 2-hydroxyethyl bis(2-acryloxyethyl) isocyanurate, tris(2-acryloxyethyl) isocyanurate, tris(2-methacryloxyethyl) isocyanurate, bis(2-acryloxyethyl) 2-[(5-acryloxyhexyl)-oxy]ethyl isocyanurate, tris(1,3-diacryloxy-2-propyloxycarbonylamino-n-hexyl) isocyanurate, tris(1-acryloxyethyl-3-methacryloxy-2-propyloxycarbonylamino-n-hexyl) isocyanurate, and tris(4-acryloxy-n-butyl) isocyanurate.

In the invention, as the radiation-polymerizable compound (B), one or more radiation-polymerizable compounds in a monomer form (e.g., the above-described cyanurate compounds containing carbon-carbon double bond(s) and isocyanurate compounds containing carbon-carbon double bond(s)) may be preferably used. Further, examples of the radiation-polymerizable compound (B) in an oligomer form include oligomers of the above-described cyanurate compounds containing carbon-carbon double bond(s) and isocyanurate compounds containing carbon-carbon double bond(s).

### Radiation-Curable Pressure-Sensitive Adhesive Layer

The pressure-sensitive adhesive tape or sheet for application to an active surface in dicing has a constitution including a substrate and, formed on at least one side thereof, a radiation-curable pressure-sensitive adhesive layer which contains the acrylic polymer (A) and the radiation-polymerizable compound (B), in which the ratio of the radiation-polymerizable compound (B) with respect to 100 parts by weight of the acrylic polymer (A) is 5 to 150 parts by weight (preferably 20 to 120 parts by weight). Herein, this pressure-sensitive adhesive layer is often referred to as "radiation-curable pressure-sensitive adhesive layer (X)". In case where the ratio of the acrylic polymer (A) to the radiation-polymerizable compound (B) is such that the ratio of the radiation-polymerizable compound (B) with respect to 100 parts by weight of the acrylic polymer (A) is smaller than 5 parts by weight, the formation of a three-dimensional network structure in the radiation-curable pressure-sensitive adhesive layer (X) by irradiation with a radiation is insufficient. Consequently, the adhesive force (element-fixing adhesive force) cannot be reduced to such a degree that the elements (chips) can be easily picked up. On the other hand, in case where the ratio of the acrylic polymer (A) to the radiation-polymerizable compound (B) is such that the ratio of the radiation-polymerizable compound (B) with respect to 100 parts by weight of the acrylic polymer (A) exceeds 150 parts by weight, the effect of plasticizing the radiation-curable pressure-sensitive adhesive layer (X) is so high that an element-fixing adhesive force which is sufficient to enable the work to withstand the impact force caused by cutting with a rotating blade (circular blade) during dicing or the pressure of cleaning water cannot be exhibited.

As described above, the radiation-curable pressure-sensitive adhesive layer (X) is constituted of a pressure-sensitive adhesive composition containing at least the acrylic polymer (A) and the radiation-polymerizable compound (B) in a given proportion (the composition is often referred to as "radiation-curable pressure-sensitive adhesive composition" hereinafter). It is preferred that the radiation-curable pressure-sensitive adhesive composition contains a photopolymerization initiator so as to enable the radiation-polymerizable compound (B) to efficiently polymerize or cure upon irradiation with a radiation. Examples of the photopolymerization initiator include benzoin alkyl ether initiators such as benzoin methyl ether, benzoin ethyl ether, benzoin propyl ether, benzoin isopropyl ether, and benzoin isobutyl ether; benzophenone initiators such as benzophenone, benzoylbenzoic acid, 3,3'-dimethyl-4-methoxybenzophenone, and polyvinylbenzophenone; aromatic ketone initiators such as α-hydroxycyclohexyl phenyl ketone, 4-(2-hydroxyethoxy)phenyl 2-hydroxy-2-propyl ketone, α-hydroxy-α,α'-dimethylacetophenone, methoxyacetophenone, 2,2-dimethoxy-2-phenylacetophenone, 2,2-diethoxyacetophenone, and 2-methyl-1-[4-(methylthio)phenyl]-2-morpholinopropane-1-one; aromatic ketal initiators such as benzyl dimethyl ketal; thioxanthone initiators such as thioxanthone, 2-chlorothioxanthone, 2-methylthioxanthone, 2-ethylthioxanthone, 2-isopropylthioxanthone, 2-dodecylthioxanthone, 2,4-dichlorothioxanthone, 2,4-dimethylthioxanthone, 2,4-diethylthioxanthone, and 2,4-diisopropylthioxanthone; benzil initiators such as benzil; and benzoin initiators such as benzoin. Examples thereof further include α-ketol compounds (such as 2-methyl-2-hydroxypropiophenone), aromatic sulfonyl chloride compounds (such as 2-naphthalenesulfonyl chloride), optically active oxime compounds (such as 1-phenone-1,1-propanedione-2-(O-ethoxycarbonyl)oximes), camphorquinone, halogenated ketones, acylphosphine oxides, and acylphosphonates. Such photopolymerization initiators can be used alone or in combination of two or more thereof.

The amount of the photopolymerization initiator to be incorporated can be suitably selected in the range of 0.5 to 30 parts by weight (preferably 1 to 20 parts by weight) per 100 parts by weight of the radiation-polymerizable compound (B). In the case where a double-bond-containing acrylic polymer is used as the acrylic polymer (A), the amount of the photopolymerization initiator to be incorporated can be suitably selected in the range of 0.5 to 30 parts by weight (preferably 1 to 20 parts by weight) per 100 parts by weight of the sum of the double-bond-containing acrylic polymer (A) and the radiation-polymerizable compound (B) because the initiator is used also for curing the double-bond-containing acrylic polymer.

The radiation-curable pressure-sensitive adhesive composition for forming the radiation-curable pressure-sensitive adhesive layer (X) may contain conventional additives or ingredients such as a crosslinking agent, tackifier, filler, flame retardant, age resistor, antistatic agent, softener, ultraviolet absorber, antioxidant, plasticizer, surfactant, and colorant according to the necessity. The crosslinking agent to be used can be suitably selected from conventional crosslinking agents (e.g., polyisocyanate crosslinking agents) as described above. In the case where the acrylic polymer (A) is to be crosslinked with a crosslinking agent, it is important to use a crosslinking agent having reactivity with a functional group of the acrylic polymer (A). Specifically, when the acrylic polymer (A) is an acrylic polymer having a functional group such as hydroxyl or carboxyl (e.g., a double-bond-containing acrylic polymer having hydroxyl groups), then a polyisocyanate crosslinking agent can be advantageously used as the crosslinking agent. Examples of the polyisocyanate crosslinking agent include tolylene diisocyanate, hexamethylene diisocyanate, trimethylolpropane triisocyanate, diphenylmethane diisocyanate, the dimer and trimer of diphenylmethane diisocyanate, products of the reaction of trimethylolpropane and tolylene diisocyanate, products of the reaction of trimethylolpropane and hexamethylene diisocyanate, polymethylene-polyphenyl isocyanate, polyether polyisocyanates, and polyester polyisocyanates.

Besides the radiation-polymerizable compound (B), one or more of other optional radiation-polymerizable compounds may be contained in the radiation-curable pressure-sensitive adhesive composition. The optional radiation-polymerizable compounds can be suitably selected from conventional radiation-polymerizable compounds. Examples thereof include low-molecular radiation-polymerizable compounds such as trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-tetramethylene glycol diacrylate, 1,6-hexanediol diacrylate, and polyethylene glycol diacrylate; and high-molecular radiation-polymerizable compounds (radiation-curable resins) such as ester (meth)acrylates, urethane (meth)acrylates, epoxy (meth)acrylates, melamine (meth)acrylates, and acrylic resin (meth)acrylates each having (meth)acryloyl groups at the molecular ends and thiol-ene addition type resins, and cationically photopolymerizable resins each having allyl groups at the molecular ends, poly(vinyl cinnamate), diazotized aminonovolak resins, and acrylamide polymers.

The radiation-curable pressure-sensitive adhesive layer (X) can be prepared by using a pressure-sensitive adhesive composition (radiation-curable pressure-sensitive adhesive composition) containing the acrylic polymer (A) and the radiation-polymerizable compound (B) in a given proportion, by a conventional method of preparing a pressure-sensitive adhesive layer. For example, the radiation-curable pressure-sensitive adhesive layer (X) can be formed by a method which includes applying the radiation-curable pressure-sensitive adhesive composition to a given side of a substrate to form a layer or a method which includes applying the radiation-curable pressure-sensitive adhesive composition on a separator (e.g., a plastic film or sheet coated with a release agent) to form a radiation-curable pressure-sensitive adhesive layer and then transferring the radiation-curable pressure-sensitive adhesive layer to a given side of a substrate.

The radiation-curable pressure-sensitive adhesive layer (X) may have a single-layer constitution or a multilayer constitution.

The thickness of the radiation-curable pressure-sensitive adhesive layer (X) is not particularly limited. However, it is preferably in the range of from 1 to 50 µm, especially preferably in the range of from 3 to 20 µm. There are cases where a work which has been bonded to the pressure-sensitive adhesive tape or sheet for application to an active surface in dicing vibrates during dicing. In this case, when the amplitude of vibration is large, the cut pieces (chips) of the work may get chipped. However, by regulating the thickness of the radiation-curable pressure-sensitive adhesive layer (X) to 50 µm or smaller, the amplitude of the vibration occurring during dicing of work can be inhibited from becoming too large. As a result, the diminution of the phenomenon in which chips suffer chipping (diminution of the so-called "chipping") can be effectively attained. Furthermore, by regulating the thickness of the radiation-curable pressure-sensitive adhesive layer (X) to 1 µm or larger, a work which has been bonded to the radiation-curable pressure-sensitive adhesive layer (X) can be held without fail so as to prevent the work from readily separating from the adhesive layer (X) during dicing. In particular, by regulating the thickness of the radiation-curable pressure-sensitive adhesive layer (X) to 3 to 20 µm, a further diminution in chipping can be attained and the work can be fixed with higher certainty during dicing. As a result, the occurrence of dicing failures can be effectively inhibited or prevented.

### Substrate

In the pressure-sensitive adhesive tape or sheet for application to an active surface in dicing, the substrate is not particularly limited. The substrate may be any of a plastic substrate, a metal substrate, substrate made of fibers, substrate made of paper, and the like, and it is preferred to use a plastic substrate. Examples of the plastic substrate include plastic films or sheets. Examples of the materials constituting the plastic films or sheets include polyolefin resins (e.g., low-density polyethylene, linear polyethylene, medium-density polyethylene, high-density polyethylene, ultralow-density polyethylene, propylene random copolymers, propylene block copolymers, propylene homopolymers, polybutene, and polymethylpentene), ethylene/vinyl acetate copolymers, ionomer resins, ethylene/(meth)acrylic acid copolymers, ethylene/(meth)acrylic ester copolymers (e.g., random copolymers and alternating copolymers), ethylene/butene copolymers, ethylene/hexene copolymers, polyurethanes, polyester resins (e.g., poly(ethylene terephthalate), poly(ethylene naphthalate), poly(butylene terephthalate), and poly(butylene naphthalate)), polyimides, polyamides, polyetherketones, polyethers, polyethersulfones, polystyrene resins (e.g., polystyrene), poly(vinyl chloride), poly(vinylidene chloride), poly(vinyl alcohol), poly(vinyl acetate), vinyl chloride/vinyl acetate copolymers, polycarbonates, fluororesins, cellulosic resins, and materials obtained by crosslinking these resins. These constituent materials may be used alone or in combination of two or more thereof. The constituent material of the plastic film or sheet may have functional groups incorporated therein according to the necessity, or may be one onto which a functional monomer or modifying monomer is grafted.

The surface of the plastic substrate may have undergone a conventional or common surface treatment (e.g., a chemical or physical treatment such as corona discharge treatment, chromic acid treatment, ozone exposure treatment, flame exposure treatment, high-voltage electric-shock exposure treatment, or ionizing radiation treatment, coating with an undercoat, priming, matting, or crosslinking) so as to have the enhanced property of adhering to or holding the adjacent layer(s) (the radiation-curable pressure-sensitive adhesive layer (X), etc.). The plastic substrate may have a vapor-deposited layer of a conductive substance such as a metal, alloy, or oxide thereof so as to have antistatic properties. The thickness of the vapor-deposited layer of such a conductive substance is generally about 30 to 500 Å.

The substrate preferably is one which at least partly transmits a radiation (e.g., X-rays, ultraviolet, or electron beams) so that the radiation-curable pressure-sensitive adhesive layer (X) formed on the substrate can be cured by irradiating the layer (X) with a radiation even from the substrate side.

The substrate may have a single-layer constitution or a multilayer constitution. The substrate may contain conventional additives or ingredients such as, e.g., a filler, flame retardant, age resistor, antistatic agent, softener, ultraviolet absorber, antioxidant, plasticizer, and surfactant according to the necessity.

Methods for forming the substrate are not particularly limited, and one suitably selected from conventional or common formation methods can be employed. Examples of methods for forming a plastic substrate include calender film formation, cast film formation, inflation extrusion, and T-die extrusion. In the case of a plastic substrate having a constitution in which multilayer is laminated, it can be formed by a laminating technique such as coextrusion or dry laminating. The plastic substrate may be in an unstretched state or may have undergone a stretching treatment and be in a uniaxially or biaxially stretched state.

The thickness of the substrate is not particularly limited and may be suitably determined. It is, for example, in the range of from 10 to 300 µm, preferably in the range of from 30 to 200 µm.

Pressure-Sensitive Adhesive Tape or Sheet for Application to Active Surface in Dicing

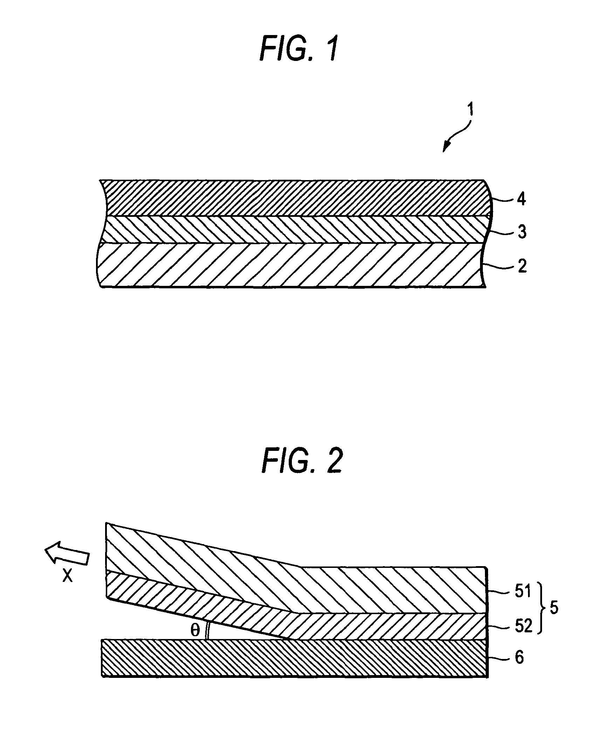

As shown in Fig. 1, the pressure-sensitive adhesive tape or sheet for application to an active surface in dicing of the invention has a constitution including a substrate and a radiation-curable pressure-sensitive adhesive layer (X) formed on at least one side (on one side or each side) of the substrate. It is preferred that the radiation-curable pressure-sensitive adhesive layer (X) be protected with a separator.

Fig. 1 is a diagrammatic sectional view illustrating one embodiment of the pressure-sensitive adhesive tape or sheet for application to an active surface in dicing of the invention. In Fig. 1, numeral 1 denotes a pressure-sensitive adhesive tape or sheet for application to an active surface in dicing, numeral 2 denotes a substrate, numeral 3 denotes a radiation-curable pressure-sensitive adhesive layer, and numeral 4 denotes a separator. The pressure-sensitive adhesive tape or sheet 1 for application to an active surface in dicing shown in Fig. 1 has a constitution including a substrate 2, a radiation-curable pressure-sensitive adhesive layer 3 formed on one side of the substrate 2, and a separator 4 with which the radiation-curable pressure-sensitive adhesive layer 3 is protected. In the pressure-sensitive adhesive tape or sheet 1 for application to an active surface in dicing shown in Fig. 1, the radiation-curable pressure-sensitive adhesive layer 3 is the radiation-curable pressure-sensitive adhesive layer X described above (i.e., a radiation-curable pressure-sensitive adhesive layer containing the acrylic polymer (A) and the radiation-polymerizable compound (B) in a given proportion). The substrate 2 is as described above.

As shown in Fig. 1, the pressure-sensitive adhesive tape or sheet for application to an active surface in dicing of the invention preferably has a constitution (embodiment) in which the radiation-curable pressure-sensitive adhesive layer (X) is formed on one side of a substrate. Further, according to the necessity, it may have a constitution in which the radiation-curable pressure-sensitive adhesive layer (X) is formed on each side of a substrate, or may have a constitution including a substrate, the radiation-curable pressure-sensitive adhesive layer (X) formed on one side of the substrate, and a pressure-sensitive adhesive layer other than the radiation-curable pressure-sensitive adhesive layer (X) (e.g., another radiation-curable pressure-sensitive adhesive layer, a heat-strippable pressure-sensitive adhesive layer, or an ordinary pressure-sensitive adhesive layer which does not have the property of becoming strippable upon irradiation with a radiation or heating) formed on the other side of the substrate.

As stated above, the pressure-sensitive adhesive tape or sheet for application to an active surface in dicing may have a separator according to the necessity for the purpose of, e.g., protecting a pressure-sensitive adhesive layer (e.g., the radiation-curable pressure-sensitive adhesive layer (X)). The separator is not particularly limited, and one suitably selected from conventional separators can be used. Examples of the constituent material of the separator (material of the base) include papers; and synthetic resin films constituted of synthetic resins such as polyethylene, polypropylene, and poly(ethylene terephthalate). A surface of the separator may have undergone a releasant treatment (releasability-imparting treatment) such as, e.g., a silicone treatment, treatment with a long-chain alkyl type releasant, or fluorochemical treatment so as to have enhanced releasability from the pressure-sensitive adhesive layer according to need. Furthermore, the separator may have undergone an ultraviolet-shielding treatment according to the necessity so as to prevent the pressure-sensitive adhesive layer (in particular, the radiation-curable pressure-sensitive adhesive layer (X)) from reacting by the action of environmental ultraviolet. The thickness of the separator is not particularly limited, and it is generally in the range of from 10 to 200 µm (preferably 25 to 100 µm).

In the invention, when the pressure-sensitive adhesive tape or sheet for application to an active surface in dicing has a constitution in which the radiation-curable pressure-sensitive adhesive layer (X) is formed on one side of the substrate, then this pressure-sensitive adhesive tape or sheet may have, formed on the other side of the substrate, a pressure-sensitive adhesive layer other than the radiation-curable pressure-sensitive adhesive layer (X) (pressure-sensitive adhesive layer of another kind), a releasing layer formed by a releasability-imparting treatment, etc. The pressure-sensitive adhesive layer of another kind is not particularly limited, and may be any pressure-sensitive adhesive layer selected from radiation-curable pressure-sensitive adhesive layers other than the radiation-curable pressure-sensitive adhesive layer (X), heat-strippable pressure-sensitive adhesive layers having strippability upon heating, ordinary pressure-sensitive adhesive layers which do not become strippable upon heating or irradiation with a radiation, and the like. For forming the pressure-sensitive adhesive layer of another kind, use may be made of, for example, a pressure-sensitive adhesive composition containing at least one pressure-sensitive adhesive selected from conventional pressure-sensitive adhesives (acrylic pressure-sensitive adhesives, rubber-based pressure-sensitive adhesives, urethane pressure-sensitive adhesives, silicone pressure-sensitive adhesives, polyester pressure-sensitive adhesives, polyamide pressure-sensitive adhesives, epoxy pressure-sensitive adhesives, vinyl alkyl ether pressure-sensitive adhesives, fluororesin pressure-sensitive adhesives, etc.) and optional various additives, a radiation-polymerizable compound, a blowing agent, etc. On the other hand, the release agent (releasant) to be used for forming a releasing layer on the other side of the substrate is not particularly limited, and use may be made of one suitably selected from conventional release agents (silicone release agents, long-chain alkyl type release agents, fluorochemical release agents, etc.).

The pressure-sensitive adhesive tape or sheet for application to an active surface in dicing may be in a roll form or in the form of a stack of sheets. When the pressure-sensitive adhesive tape or sheet for application to an active surface in dicing is used for the dicing of a semiconductor wafer, it is applied thereto generally after being cut into a given shape.

It is important that the pressure-sensitive adhesive tape or sheet for application to an active surface in dicing should be applied to a surface in the state of being not wholly covered with a native oxide film (active surface). In the active surface, active atoms in an unoxidized state (often referred to as "active atoms" hereinafter) are present. These active atoms have the property of being capable of forming a chemical bond with a component of the pressure-sensitive adhesive layer. Namely, an active surface is a surface in which unoxidized-state atoms having reactivity with a component of the pressure-sensitive adhesive layer are present. In the invention, the pressure-sensitive adhesive tape or sheet for application to an active surface in dicing, even after having been kept bonded to such an active surface for a prolonged period of time, can be easily stripped from the active surface by irradiation with a radiation. The component of the pressure-sensitive adhesive layer with which active atoms can form a chemical bond is a compound having a functional group reactive with the active atoms. Examples thereof include base polymers, tackifier resins, and radiation-polymerizable compounds.

Examples of the work having an active surface include semiconductor wafers, semiconductor packages, glasses, and ceramics. Such works employs a compound such as a silicon compound, germanium compound, or gallium-arsenic compound as the material. After such a work is subjected to back grinding or the like to expose a new surface (fresh surface), active atoms in an unoxidized state, such as active silicon atoms (Si) in an unoxidized state, active germanium atoms (Ge) in an unoxidized state, or active gallium atoms (Ga) in an unoxidized state, are present in the newly exposed surface. Incidentally, these active atoms can be deactivated through oxidation with the lapse of time (oxidation by natural exposure) or by forced oxidation, etc. to thereby become inactive.

Even after the pressure-sensitive adhesive tape or sheet for application to an active surface in dicing of the invention has been kept bonded to that active surface of a work which was exposed by grinding or the like and has active atoms which have not been deactivated, i.e., in an active state, for the purpose of reducing the thickness etc., in order to improve tact time or protect the work having a reduced thickness, it can be easily stripped, regardless of the period of bonding, by effectively reducing the force of adhesion to the active surface of the work by irradiation with a radiation. Consequently, even when the pressure-sensitive adhesive tape or sheet for application to an active surface in dicing is applied, subsequently to or shortly after a wafer back grinding step or a grinding dust layer removal step (step of mechanical grinding dust layer removal, chemical grinding dust layer removal, or grinding dust layer removal by both) conducted after the wafer back grinding step, to an active surface newly exposed by the grinding (i.e., even when the pressure-sensitive adhesive tape or sheet is thus applied in a mounting step), this pressure-sensitive adhesive tape or sheet can be effectively utilized in subsequent steps such as a dicing step and a pickup step. Specifically, before the dicing step, the pressure-sensitive adhesive tape or sheet for application to an active surface in dicing has the function of effectively protecting the brittle work having a reduced thickness (e.g., semiconductor wafer). In the dicing step, the pressure-sensitive adhesive tape or sheet has the function of highly tenaciously fixing the work and enabling it to be efficiently diced. Furthermore, in the pickup step, the pressure-sensitive adhesive tape or sheet can be effectively reduced in the force of adhesion to the work by irradiation with a radiation and thereby functions to enable the chips of the work (e.g., semiconductor elements) to be easily picked up.

Consequently, the pressure-sensitive adhesive tape or sheet for application to an active surface in dicing of the invention can be advantageously used as a pressure-sensitive adhesive tape or sheet for dicing which is to be applied to an active surface in the state of being not wholly covered with a native oxide film.

In the pressure-sensitive adhesive tape or sheet for application to an active surface in dicing of the invention, the radiation-curable pressure-sensitive adhesive layer (X) has an adhesive force (in application to a silicon mirror wafer; peel angle: 15°; pulling rate: 150 mm/min; measuring temperature: 23±3°C) of preferably 2.3 N/25-mm width or lower, especially preferably 2.0 N/25-mm width or lower. When the adhesive force of the radiation-curable pressure-sensitive adhesive layer (X) of the pressure-sensitive adhesive tape or sheet for application to an active surface in dicing (peel angle: 15°; pulling rate: 150 mm/min; measuring temperature: 23±3°C) is 2.3 N/25-mm width or lower, the pressure-sensitive adhesive tape or sheet can have satisfactory suitability for the pickup of chips and is effective in diminishing the transfer of an adhesive residue. The value of the adhesive force of the radiation-curable pressure-sensitive adhesive layer (X) is one obtained by a method in which the pressure-sensitive adhesive tape or sheet for application to an active surface in dicing is applied to a surface of a silicon mirror wafer and then stripped therefrom at a measuring temperature of 23±3°C and a pulling rate of 150 mm/min, with the angle between the surface of the radiation-curable pressure-sensitive adhesive layer (X) and the surface of the silicon mirror wafer kept at 15°, as shown in Fig. 2. The reasons why the adhesive force of the radiation-curable pressure-sensitive adhesive layer (X) is specified in terms of the force of adhesion to a silicon mirror wafer are that silicon mirror wafers have constant surface roughness and are smooth and that the material of silicon mirror wafers is the same as that of the semiconductor wafer or the like for use as the work to be diced and picked up. The reason why the adhesive force is one determined at a measuring temperature of 23±3°C is that pickup is usually conducted in an environment having room temperature (23°C).

Fig. 2 is a diagrammatic sectional view illustrating a method of measuring the adhesive force of the pressure-sensitive adhesive tape or sheet for application to an active surface in dicing. In Fig. 2, numeral 5 denotes the pressure-sensitive adhesive tape or sheet for application to an active surface in dicing, numeral 51 denotes a substrate, numeral 52 denotes a radiation-curable pressure-sensitive adhesive layer (X), and numeral 6 denotes a silicon mirror wafer. Furthermore, X indicates the direction in which the pressure-sensitive adhesive tape or sheet 5 for application to an active surface in dicing is pulled for stripping (often referred to simply as "stripping direction" hereinafter), and θ indicates the angle between the surface of the radiation-curable pressure-sensitive adhesive layer (X) 52 and the surface of the silicon mirror wafer 6 at the time when the pressure-sensitive adhesive tape or sheet 5 for application to an active surface in dicing is stripped off (the angle is often referred to as "peel angle" hereinafter). In Fig. 2, the pressure-sensitive adhesive tape or sheet 5 for application to an active surface in dicing includes a substrate 51 and a radiation-curable pressure-sensitive adhesive layer (X) 52 formed on one side of the substrate 51, and the radiation-curable pressure-sensitive adhesive layer (X) 52 contains the acrylic polymer (A) and the radiation-polymerizable compound (B) in a given proportion as described hereinabove. In the method shown in Fig. 2, the pressure-sensitive adhesive tape or sheet 5 for application to an active surface in dicing which has been applied to one side of the silicon mirror wafer 6 is stripped off by pulling it at a rate of 150 mm/min in the stripping direction X at a peel angle θ kept constant at 15°. This measurement of adhesive force is made in an atmosphere of 23°C.

The pressure-sensitive adhesive tape or sheet for application to an active surface in dicing preferably has the following property. The pressure-sensitive adhesive tape or sheet is applied, on the side of the radiation-curable pressure-sensitive adhesive layer (X), to a surface of a semiconductor wafer made of silicon (silicon wafer), and this silicon wafer is diced. Subsequently, the pressure-sensitive adhesive tape or sheet is irradiated with a radiation and stripped off and, thereafter, the surface of the silicon wafer is examined by XPS to determine the carbon element proportion C₁ (%). On the other hand, the silicon wafer surface before application of the pressure-sensitive adhesive tape or sheet thereto is also examined by XPS to determine the carbon element proportion C₂ (%). With regard to the pressure-sensitive adhesive tape or sheet for application to an active surface in dicing, it is preferable that the difference between the values of C₁ and C₂ (i.e., (C₁-C₂), often referred to as "ΔC") is 5 or smaller (e.g., 1 to 5). The pressure-sensitive adhesive tape or sheet for application to an active surface in dicing which has a ΔC value of 5 or smaller is extremely less apt to cause contamination and is effective in diminishing the occurrence of so-called "adhesive transfer". The yield in work processing can hence be improved.

The carbon element proportions (carbon element proportion C₁ (%) and carbon element proportion C₂ (%)) are determined by XPS (X-ray photoelectron spectroscopy). Specifically, the carbon element proportion C₁ (%) by XPS can be determined, for example, in the following manner. The pressure-sensitive adhesive tape or sheet for application to an active surface in dicing is applied to a surface of a silicon wafer so that the radiation-curable pressure-sensitive adhesive layer (X) side comes into contact with the silicon wafer surface. Subsequently, this silicon wafer is diced, and the pressure-sensitive adhesive tape or sheet is irradiated with a radiation (such as ultraviolet or electron beams) and then stripped from the silicon wafer. Thereafter, the surface of the silicon wafer from which the pressure-sensitive adhesive tape or sheet for application to an active surface in dicing has been stripped is subjected to X-ray photoelectron spectroscopy with an X-ray photoelectron spectroscope (Model 5400, manufactured by ULVAC-PHI, Inc.) under the conditions in which X-ray source is used, MgK_{α} is set to be 15 kV (300 W), pickup angle is set to be 45° and examination area is set to be 1 mm × 3.5 mm. Thus, C₁ can be determined. On the other hand, the carbon element proportion C₂ (%) by XPS can be determined, for example, by subjecting the silicon wafer surface, before application of the pressure-sensitive adhesive tape or sheet for application to an active surface in dicing thereto, to X-ray photoelectron spectroscopy with an X-ray photoelectron spectroscope (Model 5400, manufactured by ULVAC-PHI, Inc.) under the conditions in which X-ray source is used, MgK_{α} is set to be 15 kV (300 W), pickup angle is set to be 45° and examination area is set to be 1 mm × 3.5 mm (using the same apparatus and conditions as in the determination of carbon element proportion C₁ (%)).

### Method of Picking up Chips of Work

In the method of picking up chips of a work according to the invention, the pressure-sensitive adhesive tape or sheet for application to an active surface in dicing is applied to an active surface of a work and this work is diced. Thereafter, the resultant chips are picked up. It is important that the pressure-sensitive adhesive tape or sheet for application to an active surface in dicing be applied to a work so that the surface of the radiation-curable pressure-sensitive adhesive layer (X) comes into contact with the active surface of the work. Since the pressure-sensitive adhesive tape or sheet for dicing used for the dicing of a work and the pickup of chips is the pressure-sensitive adhesive tape or sheet for application to an active surface in dicing as described above, the pickup of chips of the work can be easily conducted by irradiation with a radiation even after the pressure-sensitive adhesive tape or sheet for dicing has been kept bonded to the active surface of the work for a prolonged period. An improved yield can hence be attained. Furthermore, in the pickup method, even when a brittle semiconductor wafer (semiconductor element) having a thickness of smaller than 100 µm is used as a work, semiconductor chips obtained by dicing the semiconductor wafer into a given size can be easily picked up and the yield can be effectively improved.

As described above, the method of picking up chips of a work according to the invention includes, at least, a mounting step in which the pressure-sensitive adhesive tape or sheet for application to an active surface in dicing is applied to an active surface of a work; a dicing step for dicing the work (cutting the work into pieces) after the mounting step; and a pickup step for picking up the resultant chips of the work after the dicing step.

The mounting step is conducted in order that the pressure-sensitive adhesive tape or sheet for application to an active surface in dicing is applied to an active surface of a work. A general procedure in the mounting step includes superposing a work, e.g., a semiconductor wafer, on the pressure-sensitive adhesive tape or sheet for application to an active surface in dicing so that the active surface of the work comes into contact with the pressure-sensitive adhesive surface on the radiation-curable pressure-sensitive adhesive layer (X) side and then bonding the work to the pressure-sensitive adhesive tape or sheet for application to an active surface in dicing while pressing them with a conventional pressing device such as a pressing device employing a pressure roll. Alternatively, use may be made of a method in which a work is superposed on the pressure-sensitive adhesive tape or sheet for application to an active surface in dicing in the same manner as in the method described above in a vessel capable of pressurizing (e.g., an autoclave) and the inside of the vessel is pressurized to thereby bond the work to the pressure-sensitive adhesive tape or sheet for application to an active surface in dicing. In this bonding with pressurizing, the work may be bonded to the pressure-sensitive adhesive tape or sheet for application to an active surface in dicing while further pressing them with a pressing device. It is also possible to bond the work to the pressure-sensitive adhesive tape or sheet in a reduced-pressure chamber (vacuum chamber) in the same manner as described above. Although the temperature at which the pressure-sensitive adhesive tape or sheet is applied is not particularly limited, it is preferably in the range of form 20 to 80°C.

The dicing step is conducted in order to produce chips (e.g., semiconductor chips) of the work (e.g., semiconductor wafer) bonded to the pressure-sensitive adhesive tape or sheet for application to an active surface in dicing by dicing the work into separate pieces. In the dicing step, the dicing of the work bonded to the pressure-sensitive adhesive tape or sheet for application to an active surface in dicing is conducted in an ordinary way. In the case where the work is a semiconductor wafer, dicing is conducted usually from the circuit side of the semiconductor wafer. In this dicing step, a blade is generally rotated at a high speed to cut the work, e.g., a semiconductor wafer, into a given size. For this dicing step, use may be made of, e.g., the cutting technique called full cutting, in which the pressure-sensitive adhesive tape or sheet is also cut as well as the work. Dicing apparatus are not particularly limited, and one suitably selected from conventional dicing apparatus can be used. In the dicing step, since the work, e.g., a semiconductor wafer, is bonded and fixed to the pressure-sensitive adhesive tape or sheet for application to an active surface in dicing, the chips are inhibited or prevented from chipping or shedding. In addition, the work itself, e.g., semiconductor wafer, is inhibited or prevented from breaking.

The pickup step is conducted in order that the chips of the work bonded to the pressure-sensitive adhesive tape or sheet for application to an active surface in dicing are separated from the pressure-sensitive adhesive tape or sheet for application to an active surface in dicing and picked up. In the pickup step, the chips (e.g., semiconductor chips) of the work which are in the state of being bonded to the pressure-sensitive adhesive tape or sheet for application to an active surface in dicing are picked up. Methods for this pickup are not particularly limited, and any of various conventional pickup methods can be employed. Examples thereof include a method in which individual chips are pushed up with a needle from the side of the pressure-sensitive adhesive tape or sheet for application to an active surface in dicing and the chip thus pushed up is picked up with a pickup apparatus. It is important that the pickup be conducted after irradiation with a radiation. Irradiation with a radiation may be conducted before pickup in the pickup step or may be conducted prior to the pickup step. Examples of the radiation with which the pressure-sensitive adhesive tape or sheet is irradiated include α-rays, β-rays, γ-rays, neutron beams, electron beams, and ultraviolet. Ultraviolet is especially preferred. Various conditions for the irradiation with a radiation such as irradiation intensity and irradiation period are not particularly limited, and can be suitably set according to the necessity.

It is important that the mounting step be conducted after the wafer back grinding step and when the surface newly exposed is an active surface. Namely, it is generally important that the mounting step be conducted successively to the wafer back grinding step or to the wafer back grinding step and the subsequent step of grinding dust layer removal, etc. (i.e., immediately after the wafer back grinding step or the step of grinding dust layer removal) or shortly after the step (i.e., within several hours after completion of the wafer back grinding step or the step of grinding dust layer removal) at the time that the active surface newly exposed has not been deactivated and retains an active state. It is also important that the dicing step be conducted after the mounting step. For example, the dicing step may be conducted successively to or shortly after the mounting step, or may be conducted after the lapse of a long time from the mounting step. Furthermore, it is important that the pickup step be conducted after the dicing step. For example, the pickup step may be conducted successively to or shortly after the dicing step, or may be conducted after the lapse of a long time from the dicing step. It is a matter of course that other steps (e.g., a cleaning step and an expanding step) may be conducted between the mounting step and dicing step or between the dicing step and pickup step.

### Examples

The invention will be explained below in more detail by reference to Examples, but the invention should not be construed as being limited by the following Examples.

### EXAMPLE 1

Seventy-five parts by weight of methyl acrylate, 10 parts by weight of methoxyethyl acrylate, 10 parts by weight of N-vinylpyrrolidone, and 5 parts by weight of 2-hydroxyethyl acrylate were copolymerized in ethyl acetate by an ordinary method to obtain a solution containing an acrylic copolymer (acrylic copolymer solution A).

To the acrylic copolymer solution A were added 30 parts by weight of 2-methacryloyloxyethyl isocyanate and 0.08 parts by weight of dibutyltin dilaurate as a catalyst. The resultant mixture was reacted at 30°C for 144 hours to obtain a solution containing a side-chain double-bond type acrylic polymer having carbon-carbon double bonds at side-chain ends (weight-average molecular weight, 500,000) (the solution is referred to as side-chain double-bond type acrylic polymer solution A). This side-chain double-bond type acrylic polymer has a structure in which 90% by mole of the side-chain terminal hydroxyl groups (hydroxyl groups derived from the 2-hydroxyethyl acrylate) of the acrylic copolymer have undergone an addition reaction with the isocyanate group of the 2-methacryloyloxyethyl isocyanate.

Subsequently, 50 parts by weight of tris(2-acryloxyethyl) isocyanurate, 3 parts by weight of "Irgacure 651" (trade name; manufactured by Ciba Specialty Chemicals Co.) as a photopolymerization initiator, and 2 parts by weight of a polyisocyanate compound (trade name "Coronate L", manufactured by Nippon Polyurethane Industry Co., Ltd.) were added to the side-chain double-bond type acrylic polymer solution A. Thus, an ultraviolet-curable acrylic pressure-sensitive adhesive solution (ultraviolet-curable acrylic pressure-sensitive adhesive solution A) was obtained.

As a substrate, a film made of linear low-density polyethylene (thickness, 70 µm) one side of which had undergone a corona discharge treatment was used.

The ultraviolet-curable acrylic pressure-sensitive adhesive solution A was applied to the corona discharge-treated side of the substrate. The coating was heated at 80°C for 10 minutes to thermally crosslink the acrylic polymer. Thus, an ultraviolet-curable pressure-sensitive adhesive layer (thickness, 5 µm) was formed as a radiation-curable pressure-sensitive adhesive layer on the substrate. Subsequently, a separator was bonded to the surface of the ultraviolet-curable pressure-sensitive adhesive layer to produce an ultraviolet-curable pressure-sensitive adhesive sheet for dicing. The ultraviolet-curable pressure-sensitive adhesive layer contains an acrylic polymer having a constitution formed by crosslinking the side-chain double-bond type acrylic polymer having a weight-average molecular weight of 500,000 with the polyisocyanate compound.

### EXAMPLE 2

A side-chain double-bond type acrylic polymer solution A was obtained in the same manner as in Example 1. To this side-chain double-bond type acrylic polymer solution A were added 50 parts by weight of tris(4-acryloxy-n-butyl) isocyanurate, 3 parts by weight of "Irgacure 651" (trade name; manufactured by Ciba Specialty Chemicals Co.) as a photopolymerization initiator, and 2 parts by weight of a polyisocyanate compound (trade name "Coronate L", manufactured by Nippon Polyurethane Industry Co., Ltd.). Thus, an ultraviolet-curable acrylic pressure-sensitive adhesive solution (ultraviolet-curable acrylic pressure-sensitive adhesive solution B) was obtained.

As a substrate the same film as in Example 1 was used. Namely, a film made of linear low-density polyethylene (thickness, 70 µm) one side of which had undergone a corona discharge treatment was used.

An ultraviolet-curable pressure-sensitive adhesive sheet for dicing was produced in the same manner as in Example 1, except that the ultraviolet-curable acrylic pressure-sensitive adhesive solution B was used.

### COMPARATIVE EXAMPLE 1

A side-chain double-bond type acrylic polymer solution A was obtained in the same manner as in Example 1. To this side-chain double-bond type acrylic polymer solution A were added 50 parts by weight of an ultraviolet-curable oligomer obtained by reacting pentaerythritol triacrylate and a diisocayanate, 3 parts by weight of "Irgacure 651" (trade name; manufactured by Ciba Specialty Chemicals Co.) as a photopolymerization initiator, and 2 parts by weight of a polyisocyanate compound (trade name "Coronate L", manufactured by Nippon Polyurethane Industry Co., Ltd.). Thus, an ultraviolet-curable acrylic pressure-sensitive adhesive solution (ultraviolet-curable acrylic pressure-sensitive adhesive solution C) was obtained.

As a substrate, the same film as in Example 1 was used. Namely, a film made of linear low-density polyethylene (thickness, 70 µm) one side of which had undergone a corona discharge treatment was used.

An ultraviolet-curable pressure-sensitive adhesive sheet for dicing was produced in the same manner as in Example 1, except that the ultraviolet-curable acrylic pressure-sensitive adhesive solution C was used.

### COMPARATIVE EXAMPLE 2

Ninety-five parts by weight of methyl acrylate and 5 parts by weight of acrylic acid were copolymerized in ethyl acetate by an ordinary method to obtain a solution containing an acrylic copolymer having a weight-average molecular weight of 800,000 (acrylic copolymer solution D). To this acrylic copolymer solution D were added 50 parts by weight of an ultraviolet-curable oligomer obtained by reacting pentaerythritol triacrylate and a diisocayanate, 3 parts by weight of "Irgacure 651" (trade name; manufactured by Ciba Specialty Chemicals Co.) as a photopolymerization initiator, and 2 parts by weight of a polyisocyanate compound (trade name "Coronate L", manufactured by Nippon Polyurethane Industry Co., Ltd.). Thus, an ultraviolet-curable acrylic pressure-sensitive adhesive solution (ultraviolet-curable acrylic pressure-sensitive adhesive solution D) was obtained.

As a substrate the same film as in Example 1 was used. Namely, a film made of linear low-density polyethylene (thickness, 70 µm) one side of which had undergone a corona discharge treatment was used.

An ultraviolet-curable pressure-sensitive adhesive sheet for dicing was produced in the same manner as in Example 1, except that the ultraviolet-curable acrylic pressure-sensitive adhesive solution D was used.

### EVALUATION

The pressure-sensitive adhesive sheets for dicing obtained in Examples 1 and 2 and Comparative Examples 1 and 2 were evaluated or examined for suitability for pickup and adhesive force by the method of evaluating suitability for pickup and method of measuring adhesive force shown below. Comprehensive evaluation was further conducted based on the results of that evaluation or measurement. The evaluation results obtained are shown in Table 1.

### Method of Evaluating Suitability for Pickup

Each of the pressure-sensitive adhesive sheets for dicing obtained in the Examples and Comparative Examples was mounted on the ground side of a 6-inch semiconductor wafer (thickness, 100 µm) which had undergone back grinding under the following back grinding conditions. This mounting was conducted in an environment with a temperature of 23°C, immediately after the grinding (within 5 minutes after completion of the grinding). Subsequently, the semiconductor wafer was diced under the following dicing conditions to form semiconductor chips.

After the lapse of a given time period (6 hours or 7 days) from the mounting, the pressure-sensitive adhesive sheet for dicing was irradiated with ultraviolet from the back side thereof (irradiation period: 20 seconds; irradiation intensity: 500 mJ/cm²). Thereafter, 100 arbitrary semiconductor chips were picked up (separated from the sheet) under the following pickup conditions, and the number of semiconductor chips successfully picked up (number of pickup successes) was counted. The case where all semiconductor chips were successfully picked up was judged "good" and the other cases were judged "poor". Suitability for pickup was thus evaluated.
Back Grinding Conditions
Grinder: "DFG-840" manufactured by DISCO Corporation
One axis: #600 grinding wheel (rotation speed: 4,800 rpm; down speed P1: 3.0 µm/sec; down speed P2: 2.0 µm/sec)
Two axes: #2000 grinding wheel (rotation speed, 5,500 rpm; down speed P1: 0.8 µm/sec; down speed P2: 0.6 µm/sec)

The back side of a semiconductor wafer was ground by 30 µm in the two-axis mode and then ground so as to result in a final semiconductor wafer thickness of 100 µm.
Dicing Conditions
Dicer: "DFD-651" manufactured by DISCO Corporation
Blade: "27HECC" manufactured by DISCO Corporation
Blade rotation speed: 40,000 rpm
Dicing speed: 120 mm/sec
Dicing depth: 25 µm
Cutting mode: down cutting
Dicing size: 5.0 mm × 5.0 mm
Pickup Conditions
Die bonder: "Machinery CPS-100" manufactured by NEC Corporation
Number of pins: 4
Distance between pins: 3.5 mm × 3.5 mm
Curvature of pin tip: 0.520 mm
Pin pushing-up amount: 0.50 mm
Suction holding time: 0.2 sec
Expanding amount: 3 mm

### Method of Measuring Adhesive Force

Each of the pressure-sensitive adhesive sheets for dicing obtained in the Examples and Comparative Examples was cut into a strip having a width of 25 mm. This strip was applied to a mirror silicon wafer (silicon mirror wafer) which had been mirror-polished (trade name "CZN <100> 2.5-3.5 (4 inches)" manufactured by Shin-Etsu Semiconductor Co., Ltd.) in an atmosphere of 23°C (room temperature). Thereafter, the resultant test piece was allowed to stand for 30 minutes in the room-temperature atmosphere and then irradiated with ultraviolet from the back side of the pressure-sensitive adhesive sheet for dicing (irradiation period: 20 seconds; irradiation intensity: 500 mJ/cm²).

After the ultraviolet irradiation, the pressure-sensitive adhesive sheet for dicing was stripped off by pulling it at a pulling rate of 150 mm/min in the stripping direction X so that the angle between the surface of the pressure-sensitive adhesive layer and the surface of the mirror silicon wafer (peel angle) θ was 15°, as shown in Fig. 2, to measure the adhesive force. The pressure-sensitive adhesive sheets which gave a found value of adhesive force of 2.3 N/25-mm width or lower were judged "good", while those which gave a found value of adhesive force higher than 2.3 N/25-mm width were judged "poor". Thus, the pressure-sensitive adhesive sheets were evaluated for adhesive force.

### COMPREHENSIVE EVALUATION

The cases where all the evaluation items concerning suitability for pickup and adhesive force were "good" were judged "good". On the other hand, the cases where at least one of the evaluation items was "poor" were judged "poor". Comprehensive evaluation was thus conducted.

**Table 1**

| | | | Example | | Comparative Example | |
|---|---|---|---|---|---|---|
| | | | 1 | 2 | 1 | 2 |
| Pickup | After 6 hours | Number of pickup successes | 100 | 100 | 100 | 65 |
| | | Evaluation of suitability for pickup | good | good | good | poor |
| | After 7 days | Number of pickup successes | 100 | 100 | 90 | 19 |
| | | Evaluation of suitability for pickup | good | good | poor | poor |
| Adhesive force (15°, 150 mm/min, 23°C) | Found value (N/25 mm) | | 1.4 | 1.3 | 2.2 | 2.9 |
| | Evaluation of adhesive force | | good | good | good | poor |
| Comprehensive evaluation | | | good | good | poor | poor |

As apparent from Table 1, when the pressure-sensitive adhesive sheets for dicing according to Examples 1 and 2 were used, all the semiconductor chips could be satisfactorily picked up after the lapse of 6 hours from mounting or even after the lapse of 7 days from mounting. These pressure-sensitive adhesive sheets were ascertained to have excellent suitability for pickup.

Furthermore, the pressure-sensitive adhesive sheets for dicing according to Examples 1 and 2 further had excellent non-contaminating properties, and the surfaces of the semiconductor chips picked up therefrom had not suffered the so-called "adhesive transfer".

While the present invention has been described in detail and with reference to specific embodiments thereof, it will be apparent to one skilled in the art that various changes and modifications can be made therein without departing from the scope thereof.

This application is based on Japanese patent application No. 2006-039048 filed February 16, 2006, the entire contents thereof being hereby incorporated by reference.

## Claims

1. A pressure-sensitive adhesive tape or sheet for dicing, which comprises:
a substrate, and
a radiation-curable pressure-sensitive adhesive layer disposed on at least one side of the substrate,
said pressure-sensitive adhesive layer containing an acrylic polymer (A) having a weight-average molecular weight of 500,000 or higher and at least one radiation-polymerizable compound (B) selected from cyanurate compounds having one or more groups containing a carbon-carbon double bond and isocyanurate compounds having one or more groups containing a carbon-carbon double bond, wherein the ratio of the radiation-polymerizable compound (B) with respect to 100 parts by weight of the acrylic polymer (A) is 5 to 150 parts by weight, and
wherein said pressure-sensitive adhesive tape or sheet is to be applied to an active surface in the state of being not wholly covered with a native oxide film.

2. The pressure-sensitive adhesive tape or sheet according to claim 1, wherein the radiation-polymerizable compound (B) has, in the molecule thereof, 2 to 12 groups containing a carbon-carbon double bond.

3. The pressure-sensitive adhesive tape or sheet according to claim 2, wherein the radiation-polymerizable compound (B) has, in the molecule thereof, 3 to 10 groups containing a carbon-carbon double bond.

4. The pressure-sensitive adhesive tape or sheet according to claim 1, wherein said one or more groups containing a carbon-carbon double bond in the radiation-polymerizable compound (B) each independently are a group of at least one kind selected from vinyl, allyl, acryloxy, and methacryloxy.

5. The pressure-sensitive adhesive tape or sheet according to claim 1, wherein the acrylic polymer (A) has a weight-average molecular weight of 800,000 or higher.

6. The pressure-sensitive adhesive tape or sheet according to claim 1, wherein the acrylic polymer (A) has one or more carbon-carbon double bonds in the side chain or main chain thereof or at the ends of the main chain thereof.

7. The pressure-sensitive adhesive tape or sheet according to claim 1, wherein the ratio of the radiation-polymerizable compound (B) with respect to 100 parts by weight of the acrylic polymer (A) is 20 to 120 parts by weight.

8. A method of picking up chips of a work, which comprises:
applying the pressure-sensitive adhesive tape or sheet according to claim 1 to an active surface of a work, followed by dicing the work to prepare chips; and
picking up the chips.

## Patentansprüche

1. Druckempfindliches Klebeband bzw. druckempfindliche Klebefolie für die Chipvereinzelung (dicing), das/die umfasst:
einen Träger und
eine Schicht aus durch Strahlung aushärtbarem druckempfindlichem Klebstoff, die an wenigstens einer Seite des Trägers angeordnet ist,
wobei die Schicht aus druckempfindlichem Klebstoff ein Acrylpolymer (A) mit einem gewichtsmittleren Molekulargewicht von 500.000 oder mehr und wenigstens eine durch Strahlung polymerisierbare Verbindung (B) enthält, die aus Cyanurat-Verbindungen, die eine oder mehrere Gruppen aufweisen, die eine Kohlenstoff-Kohlenstoff-Doppelbindung enthalten, und Isocyanurat-Verbindungen ausgewählt wird, die eine oder mehrere Gruppen aufweisen, die eine Kohlenstoff-Kohlenstoff-Doppelbindung enthalten,
wobei der Anteil der durch Strahlung polymerisierbaren Verbindung (B) in Bezug auf 100 Gewichtsteile des Acrylpolymers (A) 5 bis 150 Gewichtsteile beträgt, und
wobei das druckempfindliche Klebeband bzw. die druckempfindliche Klebefolie auf eine aktive Fläche in dem Zustand aufzubringen ist, in dem sie nicht vollständig mit einem Eigenoxidfilm bedeckt ist.

2. Druckempfindliches Klebeband bzw. druckempfindliche Klebefolie nach Anspruch 1, wobei die durch Strahlung polymerisierbare Verbindung (B) in ihrem Molekül 2 bis 12 Gruppen aufweist, die eine Kohlenstoff-Kohlenstoff-Doppelbindung enthalten.

3. Druckempfindliches Klebeband bzw. druckempfindliche Klebefolie nach Anspruch 1, wobei die durch Strahlung polymerisierbare Verbindung (B) in ihrem Molekül 3 bis 10 Gruppen aufweist, die eine Kohlenstoff-Kohlenstoff-Doppelbindung enthalten.

4. Druckempfindliches Klebeband bzw. druckempfindliche Klebefolie nach Anspruch 1, wobei die eine oder die mehreren Gruppen in der durch Strahlung polymerisierbaren Verbindung (B), die eine Kohlenstoff-Kohlenstoff-Doppelbindung enthalten, jeweils unabhängig eine Gruppe wenigstens einer Art sind, die aus Vinyl-, Allyl-, Acryloxy- und Methacryloxygruppe ausgewählt wird.

5. Druckempfindliches Klebeband bzw. druckempfindliche Klebefolie nach Anspruch 1, wobei das Acrylpolymer (A) ein gewichtsmittleres Molekulargewicht von 800.000 oder mehr hat.

6. Druckempfindliches Klebeband bzw. druckempfindliche Klebefolie nach Anspruch 1, wobei das Acrylpolymer (A) eine oder mehrere Kohlenstoff-Kohlenstoff-Doppelbindungen in seiner Seitenkette oder Hauptkette oder an den Enden seiner Hauptkette hat.

7. Druckempfindliches Klebeband bzw. druckempfindliche Klebefolie nach Anspruch 1, wobei der Anteil der durch Strahlung polymerisierbaren Verbindung (B) an 100 Gewichtsteilen des Acrylpolymers (A) 20 bis 120 Gewichtsteile beträgt.

8. Verfahren zum Aufnehmen von Chips aus einem Werkstück, das umfasst:
Aufbringen des druckempfindlichen Klebebandes bzw. der druckempfindlichen Klebefolie nach Anspruch 1 auf eine aktive Fläche eines Werkstücks und anschließende Chipvereinzelung des Werkstücks, um Chips herzustellen; und
Aufnehmen der Chips.

## Revendications

1. Bande ou feuille adhésive sensible à la pression pour un quadrillage, laquelle comprend :
un substrat, et
une couche adhésive sensible à la pression durcissable par rayonnement disposée sur au moins un côté du substrat,
ladite couche adhésive sensible à la pression contenant un polymère acrylique (A) ayant un poids moléculaire moyen en poids de 500 000 ou supérieur et au moins un composé polyérisable par rayonnement (B) choisi parmi des composés de cyanurate présentant un ou plusieurs groupes contenant une double liaison carbone-carbone et des composés d'isocyanurate présentant un ou plusieurs groupes contenant une double liaison carbone-carbone, dans laquelle le rapport du composé polymérisable par rayonnement (B) par rapport à 100 parties en poids du polymère acrylique (A) est de 5 à 150 parties en poids, et
dans laquelle ladite bande ou feuille adhésive sensible à la pression doit être appliquée sur une surface active dans un état où elle n'est pas complètement recouverte d'un film d'oxyde natif.

2. Bande ou feuille adhésive sensible à la pression selon la revendication 1, dans laquelle le composé polymérisable par rayonnement (B) présente, dans sa molécule, de 2 à 12 groupes contenant une double liaison carbone-carbone.

3. Bande ou feuille adhésive sensible à la pression selon la revendication 2, dans laquelle le composé polymérisable par rayonnement (B) présente, dans sa molécule, de 3 à 10 groupes contenant une double liaison carbone-carbone.

4. Bande ou feuille adhésive sensible à la pression selon la revendication 1, dans laquelle ledit un ou lesdits plusieurs groupes contenant une double liaison carbone-carbone dans le composé polymérisable par rayonnement (B) sont chacun indépendamment un groupe d'au moins un type choisi parmi le groupe vinyle, allyle, acryloxy et méthacryloxy.

5. Bande ou feuille adhésive sensible à la pression selon la revendication 1, dans laquelle le polymère acrylique (A) présente un poids moléculaire moyen en poids de 800 000 ou supérieur.

6. Bande ou feuille adhésive sensible à la pression selon la revendication 1, dans laquelle le polymère acrylique (A) présente une ou plusieurs doubles liaisons carbone-carbone dans sa chaîne latérale ou la chaîne principale ou aux extrémités de sa chaîne principale.

7. Bande ou feuille adhésive sensible à la pression selon la revendication 1, dans laquelle le rapport du composé polymérisable par rayonnement (B) par rapport à 100 parties en poids du polymère acrylique (A) est de 20 à 120 parties en poids.

8. Procédé consistant à piéger des copeaux d'un travail, lequel comprend :
l'application de la bande ou de la feuille adhésive sensible à la pression selon la revendication 1 sur une surface active d'un travail, suivie par un quadrillage du travail pour préparer des copeaux ; et
à ramasser les copeaux.
